# EUROPÄISCHE PATENTANMELDUNG

(11) **EP 0 973 188 A1**
(43) Veröffentlichungstag der Anmeldung: **19.01.2000**
(21) Anmeldenummer: 99250235.1
(22) Anmeldetag: 15.07.1999
(51) Int. Cl.: H01L 21/027, H01L 21/266, H01L 21/308, G03F 1/14, G03F 7/20

(54) **Anordnung zur Herstellung vertikaler Strukturen in Halbleitermaterialien**

(30) Priorität: 16.07.1998 DE 19833756
(71) Anmelder: Heinrich-Hertz-Institut für Nachrichtentechnik Berlin GmbH, 10587 Berlin (DE)
(72) Erfinder: Kaiser, Ronald, 12157 Berlin (DE); Steingrüber, Ralf, 13597 Berlin (DE)
(74) Vertreter: Rudolph, Margit

(57) **Zusammenfassung**

Zur Herstellung vertikaler Strukturen in Halbleitermaterialien durch photolithographische Belichtung einer Schichtenfolge Halbleitermaterial - Lack, weist eine Anordnung hierfür mindestens eine Maske auf, die in der lateralen Ausdehnung ihrer eingebrachten Öffnung maximal der lateralen Ausdehnung der zu erzeugenden Struktur entspricht und oberhalb der Schichtenfolge angeordnet ist. Erfindungsgemäß ist diese Maske (5) mindestens in eine Richtung der lateralen Ausdehnung der zu erzeugenden vertikalen Struktur verschiebbar angeordnet. Das Tiefenprofil der zu erzeugenden vertikalen Struktur in der Lackschicht (3) ist in Abhängigkeit von der Verfahrgeschwindigkeit der verschiebbaren Maske (5) einstellbar.

## Beschreibung

Die Erfindung bezieht sich auf eine Anordnung zur Herstellung vertikaler Strukturen in Halbleitermaterialien durch photolithographische Belichtung einer Schichtenfolge Halbleitermaterial - Lack, aufweisend mindestens eine Maske, die in der lateralen Ausdehnung ihrer eingebrachten Öffnung maximal der lateralen Ausdehnung der zu erzeugenden Struktur entspricht und oberhalb bezüglich der Schichtenfolge angeordnet ist.

Es ist bekannt, vertikale Strukturen in Halbleitermaterialien (beispielsweise als Substrat oder Schicht ausgebildet) mittels dosisgesteuerter Direktbelichtung, mittels eines Schattenverfahrens oder mittels einer Graukeilmaske zu erzeugen.

Bei der dosisgesteuerten Direktbelichtung wird über die Belichtungszeit des auf das Halbleitermaterial gerichteten Elektronenstrahls in der auf dem Halbleitermaterial angeordneten Lackschicht die gewünschte Struktur mit dem Elektronenstrahl eingeschrieben, die dann mittels bekannter Ätzverfahren in das Halbleitermaterial übertragen wird. Diese Lösung ist aber technisch aufwendig und teuer, weil nur ein geringer Durchsatz bei hohen Maschinenkosten realsierbar ist.

Eine Vorrichtung, die eine genaue Positionierung einer Schlitzmaske bezüglich eines Halbleiterwafers ermöglicht, ist in DE 196 52 376.1 vorgeschlagen. Diese Vorrichtung - vergleichbar mit einer vertikalen Schablonenstruktur - ermöglicht insbesondere die Herstellung eines gewünschten Höhenprofils des Wafers, beispielsweise für die Erzeugung eines Gradienten der Ätzrate (Taperätzung insbesondere beim Ionenstrahlätzen) bzw. der Depositionsrate (Aufdampfen von Profilen), mittels dem durch die definierte Anordnung von Schlitzmaske, Fixierplatine und gespaltenen Halbleiterwafer in der vorgeschlagenen Vorrichtung, die mit ihren Bestandteilen insgesamt bewegt wird, erzeugten Schatten. Diese Vorrichtung ermöglicht die Herstellung keilähnlicher Profile im Halbleiterwafer.
Der Stand der Technik, von dem die Erfindung ausgeht, ist in DE 44 35 022 beschrieben. Eine semitransparente Maske, eine Grautonmaske mit lokal unterschiedlich ausgebildeter Transmission, deren Herstellung sehr aufwendig ist, findet in dieser Lösung Anwendung. In dieser Maske wird bereits durch die gleichmäßige Anordnung der Löcher mit variierendem Durchmesser die in den Lack zu übertragende Struktur vorgegeben, d.h. die mögliche im Halbleitermaterial zu erzeugende Struktur ist durch die Lochmaske vorbestimmt und nur für diese spezielle Struktur geeignet.

Es ist Aufgabe der Erfindung, eine Anordnung anzugeben, die mit - im Vergleich zum Stand der Technik - einfachen Mitteln und geringem technischen Aufwand die Herstellung vertikaler Strukturen in Halbleitermaterialien ermöglicht.

Die Aufgabe wird durch eine Anordnung der eingangs genannten Art dadurch gelöst, daß erfindungsgemäß diese Maske mindestens in eine Richtung der lateralen Ausdehnung der zu erzeugenden Struktur verschiebbar angeordnet ist.

Die erfindungsgemäße Anordnung mit einer verschiebbaren Maske als Verfahrmaske ermöglicht bei geringem technischen Aufwand sehr flexibel die Herstellung von vertikalen stetig oder stufenförmig verlaufenden Strukturen, beispielsweise die Herstellung einer vertikalen Rampe für Wellenleitertaper. Die Verfahrmaske, deren Öffnung in ihren Ausdehnungen maximal so groß ist wie die Ausdehnungen der zu erzeugenden Struktur im Halbleitermaterial, wird während der Belichtung der auf dem Halbleitermaterial angeordneten Lackschicht in eine Richtung oder in zwei zueinander senkrechte Richtungen verschoben. Dabei wird das Tiefenprofil in der Lackschicht über die Verfahrgeschwindigkeit der verschiebbaren Maske bestimmt. Die der zu erzeugenden Struktur angepaßte Verfahrgeschwindigkeit wird mittels eines programmierbaren Schrittmotors eingestellt.

Somit wird bei der erfindungsgemäßen Lösung nur durch die Verschiebung der beweglichen Maske mit definierter Geschwindigkeit und gleichzeitiger Belichtung sowohl die Strukturtiefe als auch die laterale Ausdehnung der zu erzeugenden Struktur bestimmt.

Damit gewährleistet die erfindungsgemäße Anordnung durch die einfache Maskierung, deren Herstellung keinen großen technischen Aufwand erfordert, durch den folgenden kommerziellen photolithographischen Belichtungsprozeß bei gleichzeitiger definierter Verschiebung der Maske die Herstellung beliebiger Tiefenprofile in der Lackschicht, die dann mittels bekannter Ätzverfahren, beispielsweise dem Ionenstrahlstrahlätzen, in das Halbleitermaterial übertragen werden.

In einer Ausführungsform der Erfindung ist eine weitere Maske unbeweglich zwischen der Lackschicht und der verschiebbar ausgebildeten Maske angeordnet ist, wobei diese eine Öffnung aufweist, deren laterale Ausdehnungen den Ausdehnungen der zu erzeugenden Struktur entsprechen.

In einer weiteren Ausführungsform der Erfindung ist vorgesehen, die beiden Ausdehnungen der verschiebbar ausgebildeten Maske kleiner als die beiden Ausdehnungen der zu erzeugenden Struktur auszubilden. Außerdem ist in diesem Falle die verschiebbar angeordnete Maske in zwei senkrecht zueinander verlaufende Richtungen bewegbar, die entsprechend den gewünschten Ausdehnungen der zu erzeugenden Struktur verlaufen. Somit ermöglicht diese Ausführungsform der Erfindung ebenfalls die Erzeugung einer vertikalen Struktur über eine definierte Fläche des Halbleitermaterials.

Das Tiefenprofil der zunächst in der Lackschicht zu erzeugenden Struktur, die dann in das Halbleitermaterial übertragen wird, ist in einer weiteren Ausführungsform der Erfindung in Abhängigkeit von der Verfahrgeschwindigkeit der während der photolithographischen Belichtung verschobenen Maske einstellbar.

In einer anderen Ausführungsform weist die verschiebbar ausgebildete Maske mehrere in einer Achse angeordnete Öffnungen auf und ist entlang dieser Achse verschiebbar angeordnet. Mit dieser Ausführungsform ist die gleichzeitige Belichtung mehrerer Strukturen in einem Arbeitsschritt möglich.

Ein Ausführungsbeispiel der Erfindung ist in den Zeichnungen dargestellt und wird im folgenden näher beschrieben.

Dabei zeigen
- Fig. 1: schematisch eine Schichtfolge, in der zunächst in der Lackschicht ein definiertes Tiefenprofil erzeugt wird, mit darüber befindlicher unbeweglicher Maske und mit über dieser angeordnet einer in eine Richtung verschiebbaren Maske;
- Fig. 2: schematisch die Übertragung des in der Lackschicht erzeugten Tiefenprofils in das Halbleitermaterial;
- Fig. 3: die Abhängigkeit der erzeugten Strukturtiefe in der Lackschicht von der Belichtungszeit.

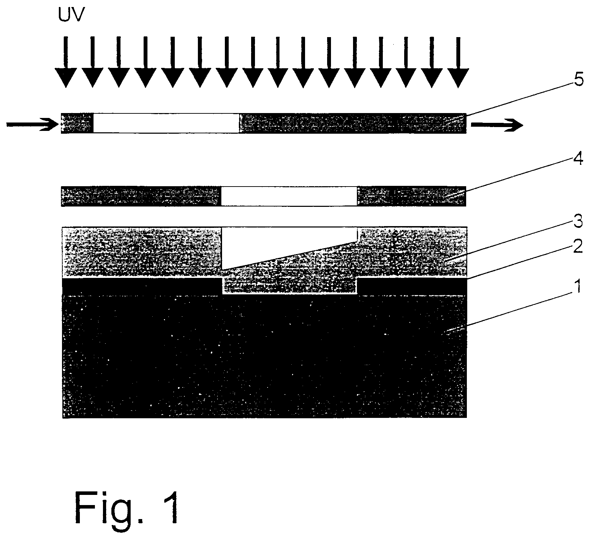

In Fig. 1 ist schematisch eine Schichtfolge Halbleitermaterial **1** - SiNₓ-Schicht **2** - Lackschicht **3** dargestellt, über der eine unbewegliche Maske **4** angeordnet ist und darüber eine in die Pfeilrichtung verschiebbar ausgebildete weitere Maske **5**. Aus technologischen Gründen soll die SiNₓ-Schicht **2** auch bei dem erfindungsgemäßen Ausführungsbeispiel in bekannter Weise die Aufgabe einer ätzresistenten dielektrischen Maske oberhalb des Halbleitermaterials erfüllen. Während der photolithographischen Belichtung fällt das UV-Licht auf die Öffnung der unbeweglichen Maske **4**. Diese Öfnung weist beispielsweise eine Fläche von 100 µm x 1000 µm auf, wodurch die laterale Ausdehung der zu erzeugenden Struktur vorgegeben ist. Die Tiefe der zu erzeugenden Struktur ist in Abhängigkeit vom Material, in dem die Struktur erzeugt werden soll, über die Verfahrgeschwindigkeit, die sich aus mit UV-Licht belichtetem Weg und der Belichtungszeit an dem gegebenen Ort ergibt, der verschiebbaren Maske **5** einstellbar. Beispielsweise beträgt für Lack AZ5214 der Firma Hoechst die Verfahrgeschwindigkeit der beweglichen Maske **5** in Abhängigkeit von der gewünschten Tiefe der zu erzeugenden Struktur 50 µm/s bis 100 µm/s. Die Verfahrgeschwindigkeit wird über einen Schrittmotor realisiert, der mittels eines Algorithmus für die Strukturtiefe angesteuert ist.

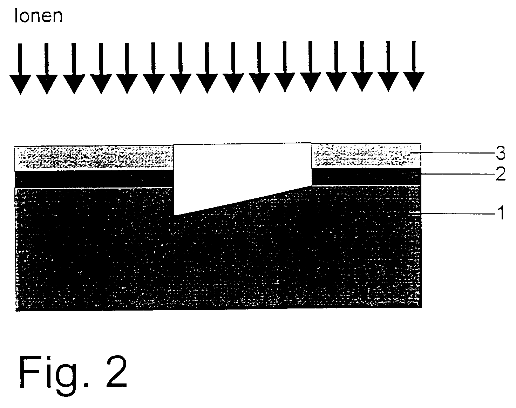

In Fig. 2 ist die Übertragung des in der Lackschicht **3** erzeugten Tiefenprofils in das Halbleitermaterial **1** dargestellt. Mittels des bekannten Ionenstrahlätzens wird nach Entfernen der beiden Masken **4** und **5** die in der Lackschicht **3** erzeugte Struktur in das Halbleitermaterial **1** abgebildet.

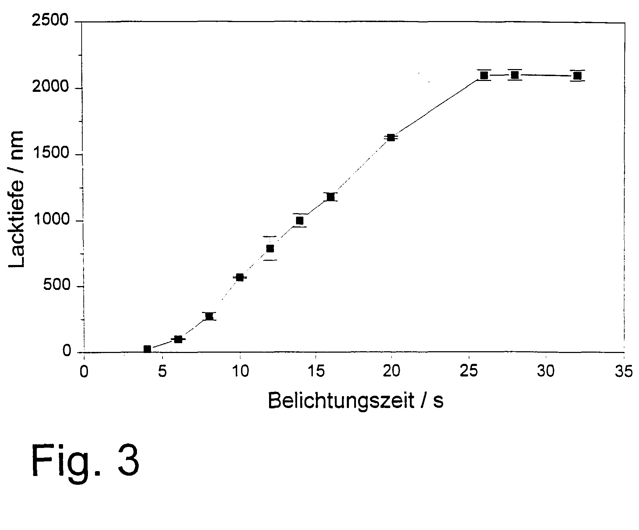

Fig. **3** zeigt die Abhängigkeit des in der Lackschicht (Lack AZ5214) einer Dicke von 2100 nm erzeugten Tiefenprofils von der Belichtungszeit. Die UV-Belichtung erfolgte mit einem Standard-Belichtungsgerät für Kontaktlithographie bei konstanter Lampenleistung (10 mW/cm²). Auf der Grundlage einer derartig festgestellten Abhängigkeit kann ein Algorithmus für die Bewegung der verschiebbaren Maske mittels Schrittmotors aufgestellt werden, um ein definiertes Tiefenprofil der einzuschreibenden vertikalen Struktur für jedes Material zu realisieren.

## Patentansprüche

1. Anordnung zur Herstellung vertikaler Strukturen in Halbleitermaterialien durch photolithographische Belichtung einer Schichtenfolge Halbleitermaterial-Lackschicht, aufweisend mindestens eine Maske, die in der lateralen Ausdehnung ihrer eingebrachten Öffnung maximal der lateralen Ausdehnung der zu erzeugenden Struktur entspricht und oberhalb der Schichtenfolge angeordnet ist,
**dadurch gekennzeichnet**, daß
diese Maske (5) mindestens in eine Richtung der lateralen Ausdehnung der zu erzeugenden vertikalen Struktur verschiebbar angeordnet ist.

2. Anordnung nach Anspruch 1,
**dadurch gekennzeichnet**, daß
eine weitere Maske (4) unbeweglich zwischen der Lackschicht (3) und der beweglich ausgebildeten Maske (5) angeordnet ist, wobei diese eine Öffnung aufweist, deren laterale Ausdehnungen den Ausdehnungen der zu erzeugenden vertikalen Struktur entsprechen.

3. Anordnung nach Anspruch 1 oder 2,
**dadurch gekennzeichnet**, daß
beide Ausdehnungen der Öffnung der verschiebbar ausgebildeten Maske (5) kleiner als die beiden Ausdehnungen der zu erzeugenden Struktur sind und die Maske (5) in zwei senkrecht zueinander befindliche Richtungen analog zu den Ausdehnungen der zu erzeugenden vertikalen Struktur verschiebbar ausgebildet ist.

4. Anordnung nach Anspruch 1 oder 2,
**dadurch gekennzeichnet**, daß
eine Ausdehnung der Öffnung der verschiebbar ausgebildeten Maske (5) kleiner als eine Ausdehnung der zu erzeugenden vertikalen Struktur ist und die Maske (5) in die Richtung dieser Ausdehnung verschiebbar ausgebildet ist.

5. Anordnung nach Anspruch 1 oder 2 und 4,
**dadurch gekennzeichnet**, daß
die verschiebbar ausgebildete Maske (5) mehrere in einer Achse angeordnete Öffnungen aufweist und entlang dieser Achse verschiebbar angeordnet ist.

6. Anordnung nach Anspruch 1,
**dadurch gekennzeichnet**, daß
das Tiefenprofil der zu erzeugenden vertikalen Struktur in der Lackschicht (3) in Abhängigkeit von der Verfahrgeschwindigkeit der verschiebbaren Maske (5) einstellbar ist.
